Europäisches Patentamt

European Patent Office

Office européen des brevets

(11) Veröffentlichungsnummer: **0 318 691**
**A2**

# (12) EUROPÄISCHE PATENTANMELDUNG

(21) Anmeldenummer: **88117515.2**

(22) Anmeldetag: **21.10.88**

(51) Int. Cl.4: **G01R 11/02**

(30) Priorität: **03.12.87 DE 3740974**
**12.12.87 DE 3742249**

(43) Veröffentlichungstag der Anmeldung:
**07.06.89 Patentblatt 89/23**

(84) Benannte Vertragsstaaten:
**AT BE CH DE ES FR GB GR IT LI LU NL SE**

(71) Anmelder: **INFAS INSTITUT FÜR**
**ANGEWANDTE SOZIALWISSENSCHAFT**
**GMBH**
**Margaretenstrasse 1**
**D-5300 Bonn 2(DE)**

(72) Erfinder: **Repschläger, Horst, Dipl.-Ing.**
**Adalbert-Stein-Weg 225**
**D-5100 Aachen(DE)**
Erfinder: **Riemer, Heinz, Dr.-Ing.**
**Tarnowitzer Strasse 10**
**D-5000 Köln 80(DE)**

(74) Vertreter: **von Rohr, Hans Wilhelm, Dipl.-Phys.**
**et al**
**Patentanwälte Gesthuysen & von Rohr**
**Huyssenallee 15 Postfach 10 13 33**
**D-4300 Essen 1(DE)**

(54) Sensor für Verbrauchsmessungen in einem Haushalts-Verbrauchsmesssystem.

(57) Ein Sensor (1) für Verbrauchsmessungen in einem Haushalts-Verbrauchsmeßsystem, bei dem das Haushalts-Verbrauchsmeßsystem als Verbrauchsmeßgeräte, insbesondere einen üblichen Elektrizitätszähler, einen üblichen Gaszähler und/oder eine übliche Wasseruhr aufweist und das Anzeigeelement (2) des jeweiligen Verbrauchsmeßgerätes hinter einer durchsichtigen Abdeckscheibe (4) angeordnet ist, bei dem der Sensor (1) ein Gehäuse (6) mit einer Austrittsseite (7) aufweist und im Gehäuse (6) ein Reflexlichtschrankensender (8) und ein Reflexlichtschrankenempfänger (9) an der Austrittsseite (7) nebeneinander angeordnet sind und bei dem der Sensor (1) an eine Auswerteeinheit angeschlossen ist, ist besonders preisgünstig herstellbar und, insbesondere, an einem Verbrauchsmeßgerät auch einfach und preisgünstig installierbar, indem das Gehäuse (6) des Sensors mit seiner Austrittsseite (7) an der Abdeckscheibe (4) des Verbrauchsmeßgerätes anlegbar und an der Abdeckscheibe (4) befestigbar ist, indem die Lage des Reflexlichtschrankensenders (8) und des Reflexlichtschrankenempfängers (9) im Gehäuse (6) gegeneinander und gegenüber der Austrittsseite (7) des Gehäuses (6) einstellbar ist und indem der Reflexlichtschrankensender (8) und der Reflexlichtschrankenempfänger (9) betriebsmäßig auf das Anzeigeelement (2) des Verbrauchsmeßgerätes ausgerichtet sind.

Fig. 2

## Sensor für Verbrauchsmessungen in einem Haushalts-Verbrauchsmeßsystem

Auch in privaten Haushalten gewinnt eine systematische Erfassung des Verbrauchs an Energie aller Art sowie von Kaltwasser und Warmwasser zunehmend an Bedeutung. Der Stand der Technik auf diesem Gebiet zeigt, daß für die unterschiedlichen Energiearten sowie für den Wasserverbrauch normalerweise unterschiedliche, speziell angepaßte Sensoren verwendet werden, nämlich für elektrische Energie ein Wirkleistungs-Meßumformer, für Gas ein an einen Gaszähler mechanisch angekoppeltes Zählwerk und für den Wasserverbrauch ein Flügelradzähler oder ein spezieller Durchflußzähler. Spezielle Sensoren für die Messung des Verbrauchs unterschiedlicher Energiearten und von Wasser sind teuer, sie können nur im Rahmen von Untersuchungen in kleinem Umfange eingesetzt werden. Untersuchungen in großem Umfange, beispielsweise in mehreren hundert oder mehreren tausend Haushalten, um langfristige Entwicklungen im Energieverbrauch beobachten zu können, benötigen extrem preisgünstige Meßtechnik.

Es ist auch ein Sensor mit Reflexlichtschrankensender und Reflexlichtschrankenempfänger - Reflexsensor - bekannt (DE-OS 30 42 411), der im Inneren eines üblichen Gaszählers angeordnet ist. Der bekannte Sensor ist dort auf einer Seite eines Justierzahnrades angeordnet, auf dessen anderer Seite eine aus reflektierendem Material bestehende Reflektorscheibe angeordnet ist. Von dem Reflexsensor geht ein Lichtstrahl aus, der durch die Lücken zwischen jeweils zwei Zähnen des Justierzahnrades hindurch auf die Reflektorscheibe trifft und von dort in den Reflexsensor reflektiert wird. Durch eine Auswerteeinheit wird die Impulsfolge der den Lichtstrahl unterbrechenden Zähne des Justierzahnrades registriert und ausgewertet.

Für eine systematische Erfassung des Verbrauchs an Energie usw. in privaten Haushalten eignet sich der bekannte, zuvor angesprochene Sensor wegen des erheblichen Aufwandes nicht oder nur im Rahmen von Untersuchungen in kleinem Umfange. Untersuchungen in großem Umfange, beispielsweise in mehreren hundert oder mehreren tausend Haushalten, die erforderlich sind, um langfristige Entwicklungen im Energieverbrauch beobachten zu können, benötigen hingegen eine extrem preisgünstige Meßtechnik, die zudem noch möglichst universell, also bei allen im üblichen Haushalt vorhandenen Verbrauchsmeßgeräten einsetzbar sein sollte.

Der Erfindung liegt unter Berücksichtigung der zuvor erläuterten Problemstellung die Aufgabe zugrunde, einen in Verbindung mit üblichen Haushalts-Verbrauchsmeßgeräten universell einsetzbaren Sensor anzugeben, der besonders preisgünstig herstellbar und, insbesondere, an einem Verbrauchsmeßgerät auch einfach und preisgünstig installierbar ist.

Der erfindungsgemäße Sensor ist durch die kennzeichnenden Merkmale von Anspruch 1 beschrieben. Die aus dem Stand der Technik bekannte Reflexlichtschrankentechnik ist eine solche, die auch in Haushalts-Verbrauchsmeßsystemen eingesetzt werden kann. Für einen universellen und installationstechnisch kostengünstigen Einsatz einer Reflexlichtschranke ist es aber wesentlich, daß diese in einem separaten Gehäuse angeordnet ist, das mit seiner Austrittsseite von außen an die Abdeckscheibe des jeweiligen Verbrauchsmeßgerätes anlegbar und daran befestigbar ist. Dadurch läßt sich der erfindungsgemäße Sensor an allen genannten Verbrauchsmeßgeräten anbringen, ein universeller Sensor kann beispielsweise für einen Elektrizitätszähler, für einen Gaszähler, für eine Wasseruhr usw. in einem Haushalt verwendet werden. Die Universalität des erfindungsgemäßen Sensors erfordert es aber, daß die Ausrichtung des Reflexlichtschrankensenders und des Reflexlichtschrankenempfängers gegenüber dem Gehäuse und damit gegenüber der Abdeckscheibe des jeweilichen Verbrauchsmeßgerätes verändert werden kann. Dem trägt die Konstruktion des erfindungsgemäßen Sensors Rechnung.

Weitere bevorzugte Ausgestaltungen und Weiterbildungen des erfindungsgemäßen Sensors in den dem Anspruch 1 nachgeordneten Ansprüchen beschrieben. Im übrigen werden bevorzugte Ausgestaltungen und Weiterbildungen des erfindungsgemäßen Sensors noch in Verbindung mit der Erläuterung eines bevorzugten Ausführungsbeispiels anhand der Zeichnung beschrieben. In der Zeichnung zeigt

Fig. 1 in schematischer Darstellung, von der Seite gesehen, ein Ausführungsbeispiel eines erfindungsgemäßen Sensors an einem Verbrauchsmeßgerät in Form eines Elektrizitätszählers,

Fig. 2 ausschnittweise, den Gegenstand aus Fig. 1 in Draufsicht und

Fig. 3 in einer schematischen Darstellung das Abtastprinzip bei einem erfindungsgemäßen Sensor in Verbindung mit einem Rollenzählwerk eines Gaszählers.

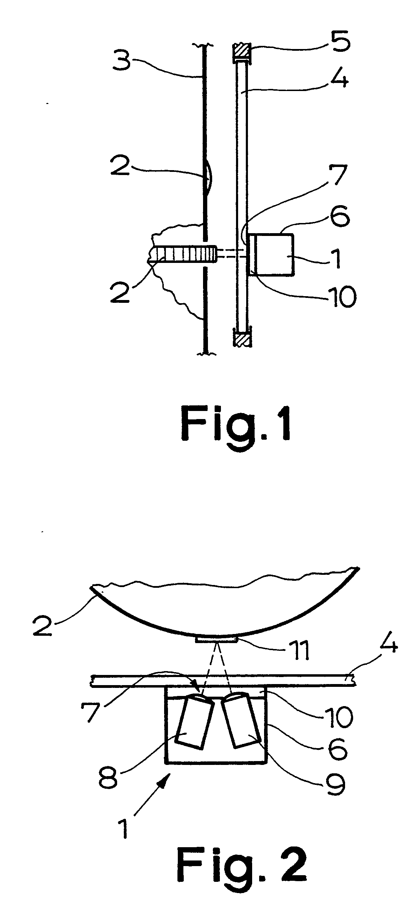

Der in Fig. 1 schematisch dargestellte Sensor 1 ist für Verbrauchsmessungen in einem Haushalts-Verbrauchsmeßsystem bestimmt und geeignet. Ein solches Haushalts-Verbrauchsmeßsystem weist eine Vielzahl von Verbrauchsmeßgeräten auf, u. a. regelmäßig einen üblichen Elektrizitätszähler und eine übliche Wasseruhr, manchmal auch einen üblichen Gaszähler, ggf. einen Fernwärmezähler usw. Den zuvor angesprochenen Verbrauchsmeßgeräten eines Haushalts-Verbrauchsmeßsystem gemeinsam ist die Tatsache, daß deren Anzeigeelemente 2 im eigentlichen Meßteil 3 jeweils hinter einer durchsichtigen Abdeckscheibe 4 angeordnet sind. Üblicherweise ist ein solcher Sensor 1 an eine zumeist elektrische oder elektronische Auswerteeinheit angeschlossen.

Fig. 1 zeigt die Abdeckscheibe 4 an einem Elektrizitätszähler als Beispiel eines Verbrauchsmeßgerätes und dahinter das Anzeigeelement 2 hier in Form eines sich um eine vertikale Achse drehenden, am Rand mit einer roten Marke versehenen Aluminiumrades. Oberhalb des Aluminiumrades findet sich im übrigen das bei Elektrizitätszählern üblicherweise vorgesehene Rollenzählwerk als weiteres Anzeigeelement 2. Die Abdeckscheibe 4 ist im übrigen in ein Gehäuse 5 des Verbrauchsmeßgerätes eingebaut, das lediglich angedeutet ist.

Wesentlich ist nun, daß bei dem erfindungsgemäßen Sensor 1 ein Gehäuse 6 mit einer an der Abdeckscheibe 4 eines Verbrauchsmeßgerätes anlegbaren Austrittsseite 7 vorgesehen und im Gehäuse 6 ein Reflexlichtschrankensender 8 sowie ein Reflexlichtschrankenempfänger 9 an der Austrittsseite 7 nebeneinander angeordnet sind, daß das Gehäuse 6, vorzugsweise mit der Austrittsseite 7, an der Abdeckscheibe 4 befestigbar, insbesondere anklebbar ist und daß der Reflexlichtschrankensender 8 und der Reflexlichtschrankenempfänger 9 auf das Anzeigeelement 2 des Verbrauchsmeßgerätes ausgerichtet sind. Im dargestellten Ausführungsbeispiel ist das Gehäuse 6 an der Austrittsseite 7 durch eine durchsichtige Austrittsscheibe 10 abgedeckt und mit dieser unmittelbar auf die Abdeckscheibe 4 des Verbrauchsmeßgerätes aufgeklebt. Als Kleber ist ein Material verwendet worden, das ungefähr den gleichen Brechungsindex wie das für beide Scheiben verwendete Kunstglas hat.

Im hier dargestellten Ausführungsbeispiel ist angedeutet, daß der Reflexlichtschrankensender 8 eine Leuchtdiode und der Reflexlichtschrankenempfänger 9 ein Fototransistor, eine Fotodiode, ein Fotowiderstand od. dgl. ist. Die Art der Leuchtdioden und Lichtempfangselemente bestimmen sich nach dem Anwendungsfall. Hier existiert ein umfangreicher genereller Stand der Technik.

Fig. 2 der Zeichnung läßt die Anordnung des erfindungsgemäßen Sensors 1 am Anzeigeelement 2 nochmals gut erkennen. Übertrieben dargestellt ist eine Marke 11 am Anzeigeelement 2, das hier die Form eines Aluminiumrads eines Elektrizitätszählers hat. Diese Marke 11 hat im allgemeinen eine bestimmte Farbe, meist Rot oder Schwarz. Insoweit zeichnet sich die dargestellte Aus führungrungsform dadurch aus, daß der Reflexlichtschrankensender 8 Licht der von der festzustellenden Marke 11 des Anzeigeelements 2 nicht oder kaum reflektierten Wellenlänge aussendet und daß am Lichtschrankenempfänger 9 das Fehlen von reflektiertem Licht als Sollsignal auswertbar ist. Erfindungsgemäß arbeitet die Reflexlichtschranke also in einem bestimmten Wellenlängenbereich und auswertungstechnisch gewissermaßen "umgekehrt" wie normale Reflexlichtschranken.

Zuvor ist darauf hingewiesen worden, daß der Reflexlichtschrankensender 8 und der Reflexlichtschrankenempfänger 9 auf das Anzeigeelement 2 des Verbrauchsmeßgerätes ausgerichtet sein sollen. Bei universeller Anwendbarkeit des erfindungsgemäßen Sensors 1 muß diese Ausrichtung veränderbar sein, da insbesondere der Längsabstand zum jeweiligen Anzeigeelement 2 bei den verschiedenen Verbrauchsmeßgeräten unterschiedlich ist. Insoweit empfiehlt es sich, daß die Lage des Reflexlichtschrankensenders 8 und des Reflexlichtschrankenempfängers 9 im Gehäuse 6 gegeneinander und gegenüber der Austrittsseite 7 einstellbar ist. Auf dem Gebiet der optoelektronischen Annäherungsschalter gibt es verschiedene Techniken, wie eine derartige Einstellbarkeit erreicht werden kann.

Zuvor ist schon erläutert worden, daß im hier dargestellten Ausführungsbeispiel die Austrittsseite 7 des Gehäuse 6 durch die Austrittsscheibe 10 abgedeckt ist. Nicht dargestellt ist, daß eine entsprechende dickere Austrittsscheibe dazu genutzt werden kann, eine unmittelbare Anbringung von Reflexlichtschrankensender 8 und der Reflexlichtschrankenempfänger 9 zu realisieren. Das ist insbesondere bei teilkreisförmig gestalteten Leuchtdioden und Fototransistoren zweckmäßig, da auf diese Weise die optischen Verluste durch unterschiedliche Brechungsindices gering gehalten werden. Entsprechendes ist in Anspruch 3 beschrieben. Die Austrittsscheibe könnte im übrigen auch von einem elastischen, für die entsprechenden Wellenlängen durchlässigen Silikon od. dgl. gebildet sein. Anspruch 4 beschreibt eine Alternative hohe Austrittsscheibe an der Austrittsseite des Gehäuses.

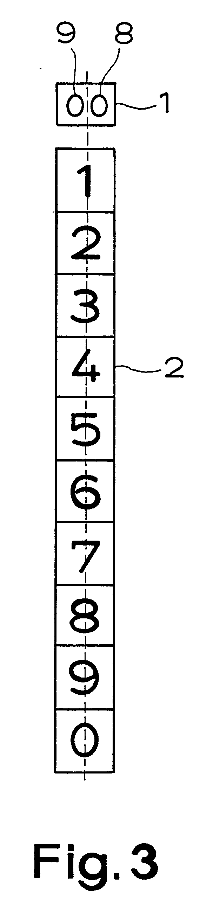

Fig. 3 zeigt, wie der universell einsetzbare Sensor 1 bei einem Rollenzählwerk eines Gaszählers eingesetzt werden kann. Bei jeden "Schwarzdurchgang" wird am Reflexlichtschrankenempfänger 9 ein Impuls ausgelöst, für eine volle Umdrehung des Rollenzählwerks in der letzten Stelle also insgesamt 25 Impulse. Ein dem Reflexlichtschrankenempfänger üblicherweise nachzuordnender Impulszähler sollte in diesem Fall eine Impulsuntersetzung 25 : 1 aufweisen, so daß letztlich vom Sensor 1 bei jeder vollen Umdrehung der letzten Stelle des Rollenzählwerks ein Ausgangsimpuls abgegeben wird.

Der Sensor 1 für Verbrauchsmessungen läßt sich im übrigen auch noch als Statusmelder für Türen und Fenster in einem Haushalt einsetzen, so daß die Verbrauchsmessungen beispielsweise für Heizenergie in Relation dazu gesetzt werden können, ob diese wegen großer äußerer Kälte, wegen schlechten Wirkungsgrads oder einfach wegen offenstehender Türen aufgewandt werden mußte.

In Anwendung bei einem Wasserzähler kann der Sensor 1 auf den roten Zeiger der Wasseruhr ausgerichtet werden, er läßt sich also in gleicher Weise wie zuvor beim Elektrizitätszähler erläutert auf die Abdeckscheibe einer Wasseruhr aufkleben.

Selbstverständlich muß elektronisch mit Abgleichvorrichtungen eine Empfindlichkeitseinstellung des Sensors 1 erfolgen können.

Wie zuvor schon mehrfach angesprochen worden ist, liegt ein wesentlicher Aspekt darin, ein Haushalts-Verbrauchsmeßsystem durch den Einsatz eines konstruktiv einheitlichen, für alle Verbrauchsmeßgeräte mit einer durchsichtigen Abdeckscheibe und einem Anzeigeelement dahinter geeigneten Sensor drastisch zu vereinfachen, so daß es umfangreich und kostengünstig eingesetzt werden kann. Dieser besondere Aspekt ist Gegenstand des Anspruchs 6, wobei für die konstruktive Gestaltung der Sensoren in diesem Haushalts-Verbrauchsmeßsystem wiederum die Merkmale der Ansprüche 1 bis 5 gelten.

Generell gilt, daß der Sensor für Verbrauchsmessungen in einem Haushalts-Verbrauchsmeßsystem auch für Verbrauchsmessungen eingesetzt werden kann, die von den Energieversorgungsunternehmen für Abrechnungszwecke od. dgl. durchgeführt werden.

**Ansprüche**

1. Sensor (1) für Verbrauchsmessungen in einem Haushalts-Verbrauchsmeßsystem, wobei das Haushalts-Verbrauchsmeßsystem als Verbrauchsmeßgeräte, insbesondere einen üblichen Elektrizitätszähler, einen üblichen Gaszähler und/oder eine übliche Wasseruhr aufweist und das Anzeigeelement (2) des jeweiligen Verbrauchsmeßgerätes hinter einer durchsichtigen Abdeckscheibe (4) angeordnet ist, wobei der Sensor (1) ein Gehäuse (6) mit einer Austrittsseite (7) aufweist und im Gehäuse (6) ein Reflexlichtschrankensender (8) und ein Reflexlichtschrankenempfänger (9) an der Austrittsseite (7) nebeneinander angeordnet sind und wobei der Sensor (1) an eine Auswerteeinheit angeschlossen ist, **dadurch gekennzeichnet,** daß das Gehäuse (6) des Sensors mit seiner Austrittsseite (7) an der Abdeckscheibe (4) des Verbrauchsmeßgerätes anlegbar und an der Abdeckscheibe (4) befestigbar ist, daß die Lage des Reflexlichtschrankensender (8) und des Reflexlichtschrankenempfängers (9) im Gehäuse (6) gegeneinander und gegenüber der Austrittsseite (7) des Gehäuses (6) einstellbar ist und daß der Reflexlichtschrankensender (8) und der Reflexlichtschrankenempfänger (9) betriebsmäßig auf das Anzeigeelement (2) des Verbrauchsmeßgerätes ausgerichtet sind.

2. Sensor (1) nach Anspruch 1, dadurch gekennzeichnet, daß der Reflexlichtschrankensender (8) Licht einer von einer festzustellenden Marke (11) des Anzeigeelements (2) nicht oder kaum reflektierten Wellenlänge aussendet und daß am Reflexlichtschrankenempfänger (9) das Fehlen von reflektiertem Licht als Sollsignal auswertbar ist.

3. Sensor (1) nach Anspruch 1 oder 2, dadurch gekennzeichnet, daß die Austrittsseite (7) des Gehäuses (6) durch eine durchsichtige Austrittsscheibe (10) abgedeckt ist und daß die durchsichtige Austrittsscheibe (10) eine größere Dicke aufweist und auf ihrer Innenseite mit dem Reflexlichtschrankensender (8) und dem Reflexlichtschrankenempfänger (9) angepaßten, vorzugsweise kugelabschnittförmigen Aufnahmen versehen ist.

4. Sensor (1) nach Anspruch 1 oder 2, dadurch gekennzeichnet, daß die Austrittsseite des Gehäuses geschlossen ist und zwei Durchtrittsöffnungen für den Reflexlichtschrankensender bzw. Reflexlichtschrankenempfänger aufweist.

5. Sensor (1) nach einem der Ansprüche 1 bis 4, dadurch gekennzeichnet, daß dem Reflexlichtschrankenempfänger (9) ein Impulszähler, insbesondere mit einer Impulsuntersetzung, nachgeschaltet ist.

6. Haushalts-Verbrauchsmeßsystem mit mehreren Verbrauchsmeßgeräten für unterschiedliche Energiearten bzw. für den Wasserverbrauch, insbesondere mit einem üblichen Elektrizitätszähler, einem üblichen Gaszähler und/oder einer üblichen Wasseruhr, und mit Sensoren für Verbrauchsmessungen der unterschiedlichen Energiearten, des Wasserverbrauchs usw., wobei die Anzeigeelemente mehrerer der Verbrauchsmeßgeräte für unterschiedliche Energiearten bzw. für Wasserverbrauch jeweils hinter einer durchsichtigen Abdeckscheibe angeordnet sind, **gekennzeichnet durch** konstruktiv identische Sensoren nach einem der Ansprüche 1 bis 5 für alle oder zumindest einige der Verbrauchsmeßgeräte.

## Fig. 1

## Fig. 2

Fig. 3